(19) Europäisches Patentamt
European Patent Office
Office européen des brevets

(11) **EP 2 225 570 B1**

(12) **EUROPÄISCHE PATENTSCHRIFT**

(45) Veröffentlichungstag und Bekanntmachung des Hinweises auf die Patenterteilung:
**13.04.2011 Patentblatt 2011/15**

(21) Anmeldenummer: **08864409.1**

(22) Anmeldetag: **11.11.2008**

(51) Int Cl.:
***G01R 31/00*** (2006.01)

(86) Internationale Anmeldenummer:
**PCT/EP2008/065310**

(87) Internationale Veröffentlichungsnummer:
**WO 2009/080405 (02.07.2009 Gazette 2009/27)**

(54) **VERFAHREN ZUR ERKENNUNG EINES ELEKTRISCHEN FEHLERS IN EINEM ELEKTRISCHEN NETZWERK EINES KRAFTFAHRZEUGS**

METHOD FOR DETECTING AN ELECTRIC FAULT IN AN ELECTRIC NETWORK OF A MOTOR VEHICLE

PROCÉDÉ DE RECONNAISSANCE D'UNE PANNE ÉLECTRIQUE DANS UN RÉSEAU ÉLECTRIQUE D'UN VÉHICULE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **20.12.2007 DE 102007061729**

(43) Veröffentlichungstag der Anmeldung:
**08.09.2010 Patentblatt 2010/36**

(73) Patentinhaber: **Robert Bosch GmbH**
**70442 Stuttgart (DE)**

(72) Erfinder:
• **PUSHKOLLI, Beqir**
**71638 Ludwigsburg (DE)**
• **KLEIN, Ulrich**
**73230 Kirchheim/Teck (DE)**

(56) Entgegenhaltungen:
**EP-A- 0 502 226        DE-A1- 4 447 446**
**DE-A1-102004 057 693   US-A- 5 163 172**

EP 2 225 570 B1

## Beschreibung

Die Erfindung betrifft ein Verfahren zur Erkennung eines elektrischen Fehlers in einem elektrischen Netzwerk eines Kraftfahrzeugs, wobei das Netzwerk mindestens eine Batterie, mindestens einen Pulswechselrichter und mindestens eine Gleichspannungswelle aufweist und ein dem Pulswechselrichter zugeordneter Zwischenkreisstrom mittels eines Zwischenkreisstromsensors ermittelt wird.

## Stand der Technik

Verfahren der eingangs genannten Art sind bekannt. Aus der DE 10 2004 057693 A1 ist ein elektrisches Netrzwerk eines Kraftfahrzeugs bekannt, wobei das Netzwerk mindestens eine Batterie, mindestens einen Pulswechselrichter und mindestens einen Gleichspannungswandler aufweist. Insbesondere bei modernen Kraftfahrzeugen mit einem Hybridantriebsstrang, also mit mindestens einer Brennkraftmaschine und mindestens einer damit mechanisch koppelbaren elektrischen Maschine, ist es häufig von Interesse, Betriebsstörungen beziehungsweise Fehler in dem elektrischen Netzwerk, zu dem die elektrische Maschine zählt, zu erfassen, um Komponenten des elektrischen Netzwerks, insbesondere den Pulswechselrichter, zu schützen. Ein derartiges Netzwerk weist in der Regel außerdem mindestens eine wiederaufladbare Batterie und mindestens einen Gleichspannungswandler auf, wobei die Batterie als Spannungsquelle für die dem Pulwechselrichter zugeordnete elektrische Maschine oder als Energiespeicher im generatorischen Betrieb der elektrischen Maschine dient. Im Falle eines Fehlers beziehungsweise einer Betriebsstörung sind unterschiedliche Möglichkeiten zum Betreiben des elektrischen Netzwerks bekannt, sodass beispielsweise beim Erfassen eines Fehlers ein Notlaufbetrieb oder eine Abschaltung des Systems erfolgt. Dabei wird häufig der Strom eines dem Pulswechselrichter zugeordneten Zwischenkreises des elektrischen Netzwerks mittels eines Zwischenkreisstromsensors ermittelt. Aufgrund von Fehlern im elektrischen Netzwerk, insbesondere aufgrund eines Fehlers in dem Zwischenkreisstromsensor, kann es dabei zu falschen Aussagen bezüglich der Funktionsfähigkeit des elektrischen Netzwerks kommen.

## Offenbarung der Erfindung

Das erfindungsgemäße Verfahren sieht vor, dass ein der Batterie zugeordneter Batteriestrom mittels eines Batteriestromsensors und ein dem Gleichspannungswandler zugeordneter Gleichspannungswandlerstrom mittels eines Gleichspannungswandlerstromsensors ermittelt werden, und dass die Größe des ermittelten Zwischenkreisstromes mit einem rechnerisch mittels des Batteriestromsensors und des Gleichspannungswandlerstromsensors bestimmten Zwischenkreisstrom auf das Überschreiten einer vorgebbaren Abweichung verglichen wird. Mittels des Batteriestromsensors und des Gleichspannungswandlerstromsensors wird der Strom des elektrischen Netzwerks an zwei weiteren Stellen des Netzwerks neben dem Zwischenkreis ermittelt beziehungsweise erfasst. Der ermittelte Batteriestrom und der ermittelte Gleichspannungswandlerstrom werden mit dem vom Zwischenkreisstromsensor ermittelten Zwischenkreisstrom verglichen, wobei hierzu aus dem Batteriestrom und dem Gleichspannungswandlerstrom rechnerisch ein Zwischenkreisstrom bestimmt wird, der mit dem ermittelten Zwischenkreisstrom verglichen wird. Weicht der rechnerisch bestimmte Zwischenkreisstrom von dem ermittelten Zwischenkreisstrom ab, so wird ein Fehler in dem elektrischen Netzwerk diagnostiziert. Dabei werden vorteilhafterweise Toleranzwerte vorgegeben, sodass der Fehler erst bei Überschreiten einer - durch die Toleranzwerte - vorgebbaren Anweichungen diagnostiziert wird. Mittels des vorteilhaften Verfahrens ist es möglich, die Zwischenkreisstromerfassung zu plausibilisieren beziehungsweise zu verifizieren, sodass bei der Erkennung eines elektrischen Fehlers in dem elektrischen Netzwerk ein Fehler des Zwischenkreisstromsensors ausgeschlossen werden kann. Wird ein Fehler erkannt, so wird beispielsweise eine Leistungsbegrenzung des Pulswechselrichters eingestellt. Der Gleichspannungswandler arbeitet vorteilhafterweise als Tiefsetzsteller.

Nach einer Weiterbildung der Erfindung wird die Abweichung des bestimmten Zwischenkreisstroms von dem ermittelten Zwischenkreisstrom mittels der folgenden Gleichung, die auf der Verwendung der Kirchhoff'schen Regel beruht, bestimmt:

$$I_{ZK} - I_{Batt} + I_{DCDC} = 0.$$

$I_{ZK}$ entspricht hierbei dem mittels des Zwischenkreisstromssensors ermittelten Zwischenkreisstrom, $I_{Batt}$ dem mittels des Batteriestromsensors ermittelten Batteriestroms und $I_{DCDC}$ dem mittels des Gleichspannungswandlerstromsensors ermittelten Gleichspannungswandlerstrom. Im motorischen Betrieb der elektrischen Maschine wird die Batterie mittels der elektrischen Maschine aufgeladen, sodass die oben angegebene Gleichung gültig ist.

Wird die elektrische Maschine generatorisch betrieben, so wird die Abweichung zweckmäßigerweise mittels der folgenden Gleichung bestimmt:

$$I_{ZK} - I_{Batt} - I_{DCDC} = 0.$$

Nach einer Weiterbildung des erfindungsgemäßen Verfahrens wird zunächst die Funktionsfähigkeit des Batteriestromsensors und/oder des Gleichspannungswandlerstromsensors ermittelt. Dies kann beispielsweise mittels sensorinterner Diagnoseprogramme erfolgen. Darüber hinaus ist es vorteilhaft, den Status des Batteriestromsensors und/oder des Gleichspannungswandlerstromsensors zu prüfen. Weiterhin ist es vorteilhaft, das Netzwerk auf "Signal-Range-Check-Fehler" (Kurschluss nach Batterie, Kurzschluss nach Masse, Leitungsunterbrechung) zu überprüfen (des Zwischenkreisstromsensors). Weiterhin ist mit Vorteil vorgesehen, dass geprüft wird, ob sich die Maschinenregelung der elektrischen Maschine in einem geeigneten Modus, wie zum Beispiel Motorbetrieb oder Generatorbetrieb, befindet.

Weiterhin betrifft die Erfindung ein Verfahren zur Erkennung eines elektrischen Fehlers in einem elektrischen Netzwerk eines Kraftfahrzeugs, wobei das Netzwerk mindestens eine Batterie, mindestens einen Pulswechselrichter und mindestens einen Gleichspannungswandler aufweist und eine dem Pulswechselrichter zugeordnete Zwischenkreisspannung mittels eines Zwischenkreisspannungssensors ermittelt wird. Erfindungsgemäß wird bei dem Verfahren eine dem Gleichspannungswandler zugeordnete Gleichspannungswandlerspannung mittels eines Gleichspannungswandlerspannungssensors ermittelt und die Größe der bestimmten Zwischenkreisspannung mit der ermittelten Gleichspannungswandlerspannung auf das Überschreiten einer vorgebbaren Abweichung verglichen. Das zweite, hier beschriebene Verfahren betrifft somit ein spannungsbasiertes Erkennen eines elektrischen Fehlers in dem elektrischen Netzwerk, wobei insbesondere die von dem Zwischenkreisspannungssensor ermittelte Zwischenkreisspannung plausibilisiert wird. Hierzu wird mittels des Gleichspannungswandlerspannungssensors die dem Gleichspannungswandler zugeordnete Gleichspannungswandlerspannung des Netzwerks ermittelt. Im Normalfall müsste die Gleichspannungswandlerspannung im Wesentlichen der Zwischenkreisspannung entsprechen, da durch den Gleichspannungswandler die Zwischenkreisspannung eingestellt wird. Ein Fehler im Netzwerk beziehungsweise ein Fehler des Zwischenkreisspannungssensors kann somit durch einen einfachen Vergleich der ermittelten Zwischenkreisspannung mit der ermittelten Gleichspannungswandlerspannung erkannt werden. Vorteilhafterweise wird dazu die Differenz zwischen der Gleichspannungswandlerspannung und der ermittelten Zwischenkreisspannung gebildet. Das zweite Verfahren unterscheidet sich hierbei also zu dem vorhergehend beschriebenen Verfahren im Wesentlichen darin, dass es spannungs- und nicht strombasiert erfolgt.

Nach einer vorteilhaften Weiterbildung des Verfahrens wird eine der Batterie zugeordnete Batteriespannung mittels eines Batteriespannungssensors ermittelt und die Größe der ermittelten Zwischenkreisspannung mit der ermittelten Batteriespannung auf das Überschreiten einer vorgebbaren Abweichung verglichen. Wie bei dem Vergleich der Gleichspannungswandlerspannung mit der Zwischenkreisspannung werden auch hier Toleranzgrenzen vorgegeben, die die vorgebbare Abweichung definieren. Überschreiten die erfassten Werte beziehungsweise die ermittelte Abweichung den Toleranzbereich, so wird ein Fehler diagnostiziert.

Vorteilhafterweise wird zusätzlich oder alternativ die ermittelte Batteriespannung mit der ermittelten Gleichspannungswandlerspannung auf das Überschreiten einer vorgebbaren Abweichung verglichen.

Vorteilhafterweise wird das (erste und/oder zweite) Verfahren bei deaktivierten Hochvoltverbrauchern durchgeführt. Zweckmäßigerweise stellt dies eine Freigabebedingung dar, die erfüllt sein muss, damit das Verfahren durchgeführt werden kann. Zusätzlich oder alternativ sind auch weitere Freigabebedingungen, die vor Durchführung des Verfahrens abgefragt werden, denkbar:

Bevorzugt wird zunächst die Funktionsfähigkeit des Batteriespannungssensors und/oder des Gleichspannungswandlersensors ermittelt. Dies kann beispielsweise mittels einer sensorinternen Diagnosefunktion erfolgen. Darüber hinaus ist es vorteilhaft, wenn durch die Freigabebedingung die Funktion der Batterie selbst überprüft wird. Ebenfalls ist es vorteilhaft, wenn der Zwischenkreisspannungssensor auf Signal-Range-Check-Fehler (Kurzschluss nach Batterie, Kurzschluss nach Masse, Leitungsunterbrechung) überprüft wird. Als weitere Freigabebedingung ist der Status der elektrischen Maschine, wie oben beschrieben, zu überprüfen.

## Kurze Beschreibung der Zeichnungen

Im Folgenden soll die Erfindung anhand einiger Zeichnungen näher erläutert werden. Dazu zeigen

Figur 1    ein Ausführungsbeispiel des erfindungsgemäßen Verfahrens und

Figur 2    ein zweites Ausführungsbeispiel des erfindungsgemäßen Verfahrens.

## Ausführungsform(en) der Erfindung

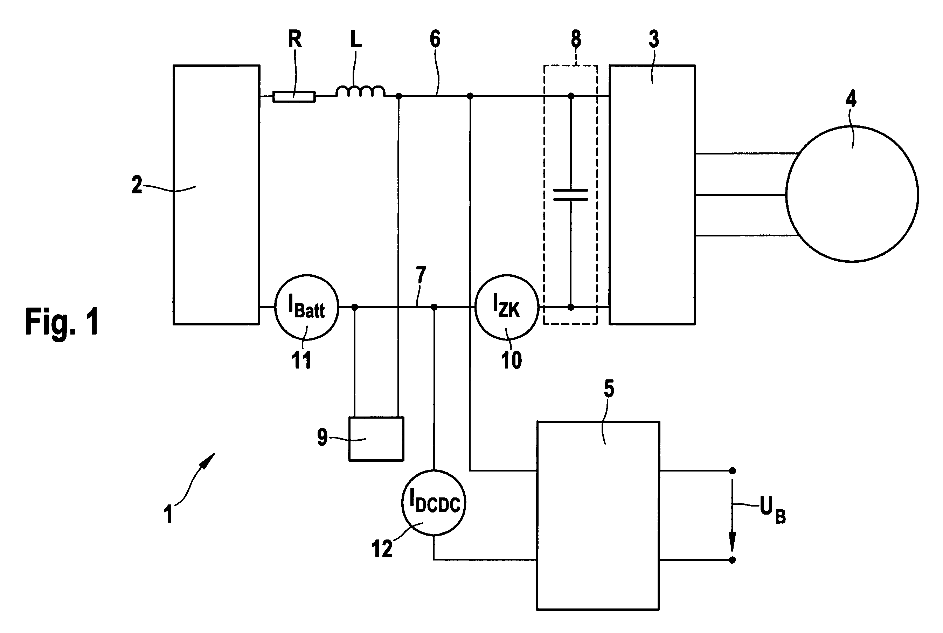

Die Figur 1 zeigt in einer schematischen Darstellung ein Ausführungsbeispiel des erfindungsgemäßen Verfahrens. Dazu ist in der Figur 1 ein vereinfachtes Schaltbild eines elektrischen Netzwerks 1 eines Kraftfahrzeugs dargestellt. Das Netzwerk 1 weist eine wiederaufladbare Batterie 2 auf, die mit einem Pulswechselrichter 3 elektrisch verbunden ist, der wiederum elektrisch mit einer elektrischen Maschine 4, zum Ansteuern dieser, verbunden ist. Weiterhin weist das Netzwerk 1 einen Gleichspannungswandler 5 auf, auf dessen einen Seite eine Spannung $U_B$ eines Bordnetzes des Kraftfahrzeugs, von beispielsweise $U_B = 14$ V anliegt. Auf einer anderen Seite ist der Gleichspannungswandler 5 mit einer ersten, die Batterie 2 mit dem Pulswechselrichter 3 verbindenden elektrischen Leitung 6 und einer zweiten, die Batterie 2 mit dem Pulswechselrichter 3 verbindenden Leitung 7 verbunden. Zwischen der Kontaktstelle des Gleichspannungswandlers mit der Leitung 6 und der Batterie 2 sind ein Widerstand R und eine Induktivität L vorgesehen, die die inneren Verluste des Netzwerks 1 darstellen. Weiterhin weist das Netzwerk 1 einen dem Pulswechselrichter 3 zugeordneten Zwischenkreis 8 auf, der hier umstrichelt dargestellt ist. Darüber hinaus können dem elektrischen Netzwerk 1 weitere Verbraucher, wie zum Beispiel ein Klima-Kompressor 9, zugeordnet sein.

In einem derartigen Netzwerk 1 ist es im Betrieb von Interesse, Betriebsstörungen beziehungsweise Fehler in dem elektrischen Netzwerk 1 zu erkennen, um Komponenten des elektrischen Netzwerks, wie zum Beispiel dem Pulswechselrichter 3, schützen zu können. So kann beispielsweise bei Erfassen einer Betriebsstörung ein Notlaufbetrieb oder eine Abschaltung des gesamten Systems erfolgen. Zum Erfassen von Betriebsstörungen ist es bekannt, den Zwischenkreisstrom $I_{ZK}$ des Zwischenkreises 8 mittels eines Zwischenkreisstromsensors 10 zu erfassen. Jedoch kann aufgrund von Fehlern in dem Zwischenkreisstromsensor 10 fälschlicherweise eine Betriebsstörung bestimmt/ermittelt werden.

Um die von dem Zwischenkreisstromsensor 10 gelieferten Werte zu verifizieren beziehungsweise plausibilisieren, wird vorteilhafterweise ein der Batterie 2 zugeordneter Batteriestrom $I_{Batt}$ mittels eines Batteriestromsensors 11 und ein dem Gleichspannungswandler 5 zugeordneter Gleichspannungswandlerstrom $I_{DCDC}$ mittels eines Gleichspannungswandlerstromsensors 12 ermittelt. Wobei die Größe des ermittelten Zwischenkreisstroms $I_{ZK}$ mit einem rechnerisch mittels des Batteriestromsensors 11 und des Gleichspannungswandlerstromssensors 12 bestimmten Zwischenkreisstrom auf das Überschreiten einer vorgebbaren Abweichung verglichen wird. Hierbei wird also der von dem Zwischenkreisstromsensor 10 erfasste Zwischenkreisstrom $I_{ZK}$ mit einem rechnerisch bestimmten Zwischenkreisstrom verglichen. Insbesondere wird das Überschreiten der vorgebbaren Abweichung geprüft, die einen Toleranzbereich definiert, innerhalb dessen eine Abweichung des ermittelten Zwischenkreisstromes $I_{ZK}$ von dem berechneten Zwischenkreisstrom als unerheblich aufgefasst wird. Überschreitet jedoch die Abweichung den vorgebbaren (Toleranz-)bereich, so wird ein Fehler diagnostiziert. Erfasst beispielsweise der Zwischenkreisstromssensor 10 einen ordnungsgemäßen Zwischenkreisstrom $I_{ZK}$, und weicht der berechnete Zwischenkreisstrom hiervon gravierend ab, wird auf einen Fehler in dem Netzwerk 1 geschlossen. Meldet der Zwischenkreisstromsensor 10 jedoch einen kritischen Zwischenkreisstrom $I_{ZK}$, und weicht der berechnete Zwischenkreisstrom hiervon gravierend ab und befindet sich in einem für das elektrische Netzwerk 1 günstigen beziehungsweise ordnungsgemäßen Bereich, so kann auf einen Fehler in dem Zwischenkreissensor 10 geschlossen werden.

Die Abweichung des ermittelten Zwischenkreisstromwerts von dem berechneten Zwischenkreisstromwert wird zweckmäßigerweise mittels der Kirchhoff'schen Regel bestimmt:

$$I_{ZK} - I_{Batt} + I_{DCDC} = 0.$$

Wobei diese Gleichung insbesondere für den motorischen Betrieb der elektrischen Maschine 4 gilt. Im generatorischen Betrieb der elektrischen Maschine wird hingegen zweckmäßigerweise die folgende Gleichung verwendet:

$$I_{ZK} - I_{Batt} - I_{DCDC} = 0.$$

Um weitere Fehlerquellen auszuschließen, wird mittels interner Vorgänge zusätzlich die Funktionsfähigkeit des Batteriestromsensors 11 und/oder des Gleichspannungswandlerstromsensors 12 ermittelt.

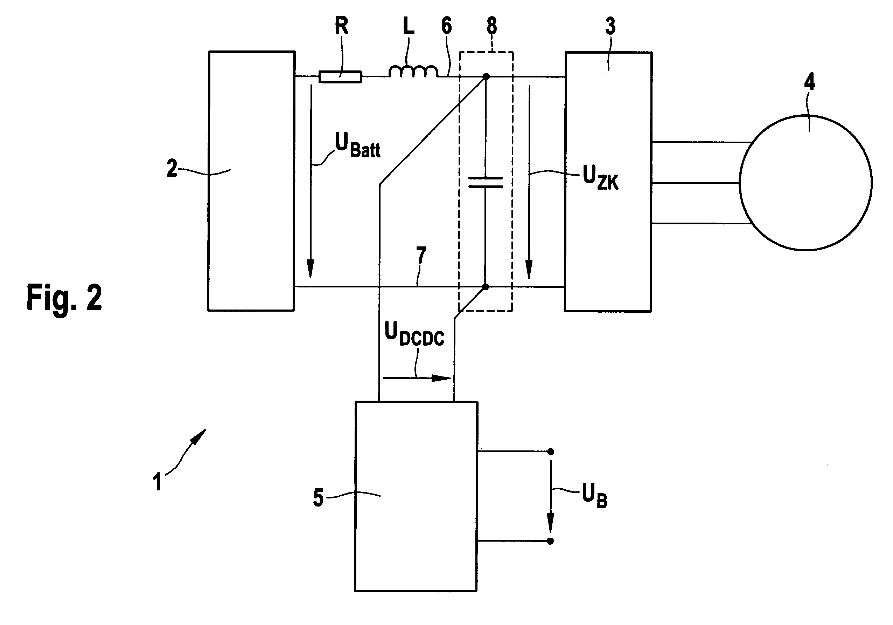

Die Figur 2 zeigt ein zweites Ausführungsbeispiel eines vorteilhaften Verfahrens zur Erkennung eines elektrischen Fehlers in dem elektrischen Netzwerk 1, das bereits aus der Figur 1 bekannt ist. Aus der Figur 1 bekannte Elemente sind hierbei mit den gleichen Bezugszeichen versehen und werden nicht nochmals erläutert.

Im Wesentlichen unterschiedet sich das Ausführungsbeispiel der Figur 2 von dem Ausführungsbeispiel der Figur 1 darin, dass nicht ein Zwischenkreisstrom $I_{ZK}$, sondern die von einem Zwischenkreisspannungssensor ermittelte Zwischenkreisspannung, die zur Ermittlung eines Fehlers im Netzwerk erfasst wird, plausibilisiert beziehungsweise verifiziert wird. Hierzu wird wie folgt vorgegangen:

Zunächst wird mittels eines Gleichspannungswandlerspannungssensors eine dem Gleichspannungswandler 5 zugeordnete Gleichspannungswandlerspannung $U_{DCDC}$ ermittelt und die Größe der ermittelten Zwischenkreisspannung $U_{ZK}$ mit der ermittelten Gleichspannungswandlerspannung $U_{DCDC}$ auf das Überschreiten einer vorgebbaren Abweichung verglichen. Im Normalfall müsste die Gleichspannungswandlerspannung $U_{DCDC}$ im Wesentlichen der Zwischenkreisspannung $U_{ZK}$ entsprechen. Durch den einfachen Vergleich der Gleichspannungswandlerspannung $U_{DCDC}$ mit der Zwischenkreisspannung $U_{ZK}$ kann somit ein Fehler des Netzwerks 1 beziehungsweise des Zwischenkreisspannungssensors auf einfache Art und Weise erkannt werden. Bevorzugt wird hierzu die Differenz zwischen der Gleichspannungswandlerspannung $U_{DCDC}$ und der ermittelten Zwischenkreisspannung $U_{ZK}$ gebildet.

Vorteilhafterweise wird zusätzlich eine der Batterie 2 zugeordnete Batteriespannung $U_{Batt}$ mittels eines Batteriespannungssensors ermittelt und die Größe der ermittelten Zwischenkreisspannung $U_{ZK}$ mit der ermittelten Batteriespannung $U_{Batt}$ auf das Überschreiten einer vorgebbaren Abweichung verglichen. Hierbei kann diese vorgebbare Abweichung entsprechend der oben beschriebenen Abweichung oder abweichend davon gewählt werden. Überschreiten die erfassten Werte beziehungsweise die Differenz der erfassten Werte den durch die vorgebbare Abweichung definierten Toleranzbereich, so wird ein Fehler in dem Netzwerk 1 oder dem Zwischenkreisspannungssensor, wie oben zu dem strombasierten Verfahren beschrieben, diagnostiziert. Darüber hinaus ist es denkbar, die ermittelte Batteriespannung $U_{Batt}$ mit der ermittelten Gleichspannungswandlerspannung $U_{DCDC}$ auf das Überschreiten einer vorgebbaren Abweichung zu vergleichen.

Zweckmäßigerweise werden die in den Figuren 1 und 2 beschriebenen Verfahren bei deaktivierten Hochvoltverbrauchern, wie zum Beispiel dem in der Figur 1 dargestellten Klimakompressor 9, durchgeführt. Diese Bedingung stellt vorteilhafterweise eine von mehreren Freigabebedingungen dar, die erfüllt sein müssen, bevor das Verfahren durchgeführt wird.

Als weitere Freigabebedingungen kann die Funktionsfähigkeit des Batteriespannungssensors und/ oder des Gleichspannungswandlersensors, beispielsweise mittels sensorinterner Diagnosefunktionen, ermittelt werden.

Insgesamt ist es durch die vorteilhaften Verfahren zur Erkennung eines elektrischen Fehlers in dem elektrischen Netzwerk 1 eines Fahrzeugs möglich, auf einfache Art und Weise die von dem Zwischenkreisstromsensor 10 und/oder die von dem Zwischenkreisspannungssensor ermittelten Werte zu plausibilisieren und somit einen von dem Zwischenkreisstromsensor beziehungsweise Zwischenkreisspannungssensor erfassten Fehler des Netzwerks und/oder des Sensors zu verifizieren, sodass beispielsweise ein ungewolltes Abschalten des elektrischen Systems des Kraftfahrzeugs vermieden wird.

**Patentansprüche**

1. Verfahren zur Erkennung eines elektrischen Fehlers in einem elektrischen Netzwerk eines Kraftfahrzeugs, wobei das Netzwerk mindestens eine Batterie, mindestens einen Pulswechselrichter und mindestens einen Gleichspannungswandler aufweist, **dadurch gekennzeichnet, dass** ein dem Pulswechselrichter zugeordneter Zwischenkreisstrom mittels eines Zwischenkreisstromsensors ermittelt wird, dass ein der Batterie zugeordneter Batteriestrom mittels eines Batteriestromsensors und ein dem Gleichspannungswandler zugeordneter Gleichspannungswandlerstrom mittels eines Gleichspannungswandlerstromsensors ermittelt werden und dass die Größe des ermittelten Zwischenkreisstromes mit einem rechnerisch mittels des Batteriestromsensors und des Gleichspannungswandlerstromsensors bestimmten Zwischenkreisstrom auf das Überschreiten einer vorgebbaren Abweichung verglichen wird.

2. Verfahren nach Anspruch 1, **dadurch gekennzeichnet, dass** zur Bestimmung der Abweichung die Kirchhoff'sche Regel verwendet wird.

3. Verfahren nach einem der vorhergehenden Ansprüche, **dadurch gekennzeichnet, dass** die Abweichung, insbesondere in einem motorischen Betrieb einer dem Pulswechselrichter zugeordneten elektrischen Maschine, mittels der Gleichung $I_{ZK}-I_{Batt}+I_{DCDC}=0$ bestimmt wird, wobei $I_{ZK}$ der ermittelte Zwischenkreisstrom, $I_{Batt}$ der ermittelte Batteriestrom und $I_{DCDC}$ der ermittelte Gleichspannungswandlerstrom ist.

4. Verfahren nach einem der vorhergehenden Ansprüche, **dadurch gekennzeichnet, dass** die Abweichung, insbesondere in einem generatorischen Betrieb der elektrischen Maschine, mittels der Gleichung $I_{ZK}-I_{Batt}-I_{DCDC}=0$ bestimmt wird.

5. Verfahren nach einem der vorhergehenden Ansprüche, **dadurch gekennzeichnet, dass** zunächst die Funktionsfähigkeit des Batteriestromsensors und/ oder des Gleichspannungswandlerstromsensors ermittelt wird.

6. Verfahren nach einem der vorhergehenden Ansprüche, **gekennzeichnet durch** die Durchführung bei deaktivierten HochvoltVerbrauchern.

7. Verfahren zur Erkennung eines elektrischen Fehlers in einem elektrischen Netzwerk eines Kraftfahrzeugs, wobei das Netzwerk mindestens eine Batterie, mindestens einen Pulswechselrichter und mindestens einen Gleichspannungswandler aufweist, **dadurch gekennzeichnet, dass** eine dem Pulswechselrichter zugeordnete Zwischenkreisspannung mittels eines Zwischenkreisspannungssensors ermittelt wird, dass eine dem Gleichspannungswandler zugeordnete Gleichspannungswandlerspannung mittels eines Gleichspannungswandlerspannungssensors ermittelt wird und dass die Größe der ermittelten Zwischenkreisspannung mit der ermittelten Gleichspannungswandlerspannung auf das Überschreiten einer vorgebbaren Abweichung verglichen wird.

8. Verfahren nach Anspruch 7, **dadurch gekennzeichnet, dass** zur Bestimmung der Abweichung die Kirchhoffsche Regel verwendet wird.

**9.** Verfahren nach Anspruch 7 oder 8, **dadurch gekennzeichnet, dass** eine der Batterie zugeordnete Batteriespannung mittels eines Batteriespannungssensors ermittelt wird und dass die Größe der bestimmten Zwischenkreisspannung mit der ermittelten Batteriespannung auf das Überschreiten einer vorgebbaren Abweichung verglichen wird.

**10.** Verfahren nach einem der vorhergehenden Ansprüche, **dadurch gekennzeichnet, dass** die ermittelte Batteriespannung mit der ermittelten Gleichspannungswandlerspannung auf das Überschreiten einer vorgebbaren Abweichung verglichen wird.

**11.** Verfahren nach einem der vorhergehenden Ansprüche, **gekennzeichnet durch** die Durchführung bei deaktivierten HochvoltVerbrauchern.

**12.** Verfahren nach einem der vorhergehenden Ansprüche, **dadurch gekennzeichnet, dass** zunächst die Funktionsfähigkeit des Batteriespannungssensors und/oder des Gleichspannungswandlerspannungssensors ermittelt wird.

**Claims**

**1.** Method for detecting an electric fault in an electric network of a motor vehicle, the network having at least one battery, at least one pulse-controlled inverter and at least one direct voltage converter, **characterized in that** a link current associated with the pulse-controlled inverter is determined by means of a link current sensor, **in that** a battery current associated with the battery is determined by means of a battery current sensor and a direct voltage converter current associated with the direct voltage converter is determined by means of a direct voltage converter current sensor and **in that** the magnitude of the link current determined is compared for exceeding a predeterminable deviation with a link current determined mathematically by means of the battery current sensor and the direct voltage converter current sensor.

**2.** Method according to Claim 1, **characterized in that** Kirchhoff's law is used for determining the deviation.

**3.** Method according to one of the preceding claims, **characterized in that** the deviation is determined, especially in a motor mode of an electric machine associated with the pulse-controlled inverter, by means of the equation $I_{ZK} - I_{Batt} + I_{DCDC} = 0$, where $I_{ZK}$ is the link current determined, $I_{Batt}$ is the battery current determined and $I_{DCDC}$ is the direct voltage converter current determined.

**4.** Method according to one of the preceding claims, **characterized in that** the deviation is determined, especially in a generator mode of the electric machine, by means of the equation $I_{ZK} - I_{Batt} - I_{DCDC} = 0$.

**5.** Method according to one of the preceding claims, **characterized in that** firstly the operability of the battery current sensor and/or of the direct voltage converter current sensor is determined.

**6.** Method according to one of the preceding claims, **characterized by** its performance with deactivated high-voltage loads.

**7.** Method for detecting an electric fault in an electric network of a motor vehicle, the network having at least one battery, at least one pulse-controlled inverter and at least one direct-voltage converter, **characterized in that** a link voltage associated with the pulse-controlled inverter is determined by means of a link voltage sensor, **in that** a direct voltage converter voltage associated with the direct voltage converter is determined by means of a direct voltage converter voltage sensor and **in that** the magnitude of the link voltage determined is compared with the direct voltage converter voltage determined for exceeding a predeterminable deviation.

**8.** Method according to Claim 7, **characterized in that** Kirchhoff's law is used for determining the deviation.

**9.** Method according to Claim 7 or 8, **characterized in that** a battery voltage associated with the battery is determined by means of a battery voltage sensor and **in that** the magnitude of the link voltage determined is compared with the battery voltage determined for exceeding a predeterminable deviation.

**10.** Method according to one of the preceding claims, **characterized in that** the battery voltage determined is compared with the direct voltage converter voltage determined for exceeding a predeterminable deviation.

**11.** Method according to one of the preceding claims, **characterized by** its performance with deactivated high-voltage loads.

**12.** Method according to one of the preceding claims, **characterized in that** initially the operability of the battery voltage sensor and/or of the direct voltage converter voltage sensor is determined.

**Revendications**

**1.** Procédé de détection d'un défaut électrique dans un réseau électrique d'un véhicule automobile, dans lequel le réseau présente au moins une batterie, au moins un onduleur pulsé et au moins un convertisseur de tension continue,

**caractérisé en ce**

**qu'**un courant de circuit intermédiaire associé à l'onduleur pulsé est déterminé au moyen d'un détecteur de courant de circuit intermédiaire,

en ce qu'un courant de batterie associé à la batterie est détecté au moyen d'un détecteur de courant de batterie,

en ce qu'un courant de convertisseur de tension continue associé au convertisseur de tension continue est détecté au moyen d'un détecteur de courant de convertisseur de tension continue et

en ce que le niveau du courant de circuit intermédiaire ainsi déterminé est comparé au courant du circuit intermédiaire déterminé par calcul au moyen du détecteur de courant de batterie et du détecteur de convertisseur de tension continue en vue de vérifier si un écart prédéterminé est dépassé.

2. Procédé selon la revendication 1, **caractérisé en ce que** les lois de Kirchhoff sont utilisées pour déterminer l'écart.

3. Procédé selon l'une des revendications précédentes, **caractérisé en ce que** l'écart, en particulier dans une machine électrique fonctionnant comme moteur et associée à l'onduleur pulsé, est déterminé au moyen de l'équation $I_{ZK}-I_{Batt}+I_{DCDC}=0$, dans laquelle $I_{ZK}$ représente le courant déterminé dans le circuit intermédiaire, $I_{Batt}$ le courant déterminé sur la batterie et $I_{DCDC}$ le courant déterminé sur le convertisseur de tension continue.

4. Procédé selon l'une des revendications précédentes, **caractérisé en ce qu'**en particulier lorsque la machine électrique fonctionne comme générateur, l'écart est déterminé au moyen de l'équation $I_{ZK}-I_{Batt}-I_{DCDC}=0$.

5. Procédé selon l'une des revendications précédentes, **caractérisé en ce qu'**on détermine d'abord le bon fonctionnement du détecteur de courant de batterie et/ou du détecteur de courant du convertisseur de tension continue.

6. Procédé selon l'une des revendications précédentes, **caractérisé en ce qu'**il est exécuté lorsque les consommateurs à haute tension ont été désactivés.

7. Procédé de détection d'un défaut électrique dans un réseau électrique d'un véhicule automobile, dans lequel le réseau présente au moins une batterie, au moins un onduleur pulsé et au moins un convertisseur de tension continue,

**caractérisé en ce**

**qu'**une tension du circuit intermédiaire associée à l'onduleur pulsé est déterminée au moyen d'un détecteur de tension de circuit intermédiaire,

en ce qu'une tension de convertisseur de tension continue associée au convertisseur de tension continue est détectée au moyen d'un détecteur de tension du convertisseur de tension continue et

en ce que le niveau de tension ainsi déterminé du circuit intermédiaire est comparé à la tension du convertisseur de tension continue pour vérifier si un écart prédéterminé est dépassé.

8. Procédé selon la revendication 7, **caractérisé en ce que**, pour déterminer l'écart, il utilise les lois de Kirchhoff.

9. Procédé selon la revendication 7 ou 8, **caractérisé en ce qu'**une tension de batterie associée à la batterie est déterminée au moyen d'un détecteur de tension de batterie et **en ce que** le niveau de la tension ainsi déterminé du circuit intermédiaire est comparé à la tension de batterie qui a été déterminée pour vérifier si un écart prédéterminé est dépassé.

10. Procédé selon l'une des revendications précédentes, **caractérisé en ce que** la tension de batterie déterminée est comparée à la tension du convertisseur de tension continue qui a été déterminée pour vérifier si un écart prédéterminé n'est pas dépassé.

11. Procédé selon l'une des revendications précédentes, **caractérisé en ce qu'**il est exécuté lorsque les consommateurs à haute tension sont désactivés.

12. Procédé selon l'une des revendications précédentes, **caractérisé en ce que** le bon fonctionnement du détecteur de tension de batterie et/ou du détecteur de tension du convertisseur de tension continue est d'abord déterminé.

**Fig. 1**

**Fig. 2**

EP 2 225 570 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004057693 A1